# EUROPEAN PATENT SPECIFICATION

(11) **EP 3 629 227 B1**
(45) Date of publication and mention of the grant of the patent: **07.12.2022**
(21) Application number: 18818105.1
(22) Date of filing: 07.06.2018
(51) Int. Cl.: H04M 1/02

(54) **DISPLAY MODULE AND MOBILE TERMINAL**
ANZEIGEMODUL UND MOBILES ENDGERÄT
MODULE D'AFFICHAGE ET TERMINAL MOBILE

(30) Priority: 14.06.2017 WO PCT/CN2017/088275
(43) Date of publication of application: 01.04.2020
(60) Divisional application: 22196779.7
(73) Proprietor: Huawei Technologies Co., Ltd., Longgang District Shenzhen, Guangdong 518129 (CN)
(72) Inventor: WANG, Fengping, Shenzhen Guangdong 518129 (CN); ZHONG, Yiliang, Shenzhen Guangdong 518129 (CN); CHENG, Yinghua, Shenzhen Guangdong 518129 (CN); ZHANG, Wentao, Shenzhen Guangdong 518129 (CN); XU, Ying, Shenzhen Guangdong 518129 (CN)
(74) Representative: Gill Jennings & Every LLP
(86) International application number: PCT/CN2018/090270
(87) International publication number: WO 2018/228269

(56) References cited:
- WO-A1-2017/070711
- CN-A- 106 709 455
- CN-A- 106 709 455
- CN-A- 106 774 685
- CN-U- 205 845 065
- US-A1- 2017 124 372

## Description

### TECHNICAL FIELD

This application relates to the field of communications technologies, and in particular, to a display module and a mobile terminal.

### BACKGROUND

A fingerprint recognition technology is a technology of identifying an individual by using fingerprints, where a real identity of a user is verified by comparing a fingerprint collected in real time with a pre-stored fingerprint. Skin texture (including fingerprints) of each person varies in patterns, breakpoints, and intersections. In other words, fingerprints of each person are unique and unchangeable in a lifetime.

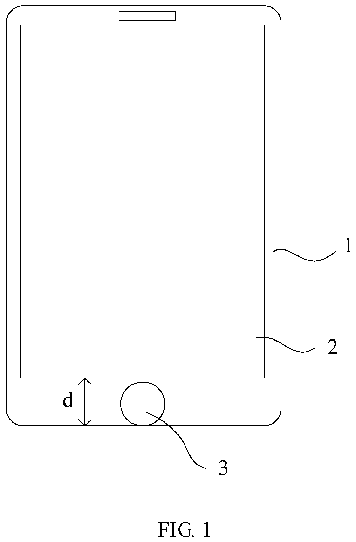

As shown in FIG. 1, in the prior art, a fingerprint unlock structure of a mobile terminal is disposed outside a display screen, that is, a dedicated area is disposed on a front panel of the mobile terminal to accommodate the fingerprint unlock structure. Because the fingerprint unlock structure independently occupies an area of the front panel, a large non-display area needs to be disposed on the front panel of the mobile terminal.

Prior art useful for understanding the present invention is disclosed in CN 106709455 A which describes a display screen using the principle of pin-hole imaging for supporting a full screen optical fingerprint sensor. US 2017/124372 A1 suggest positioning a fingerprint sensor directly beneath the display by setting a fingerprint sensor within a recess in the display assembly.

### SUMMARY

Embodiments of this application provide a display module and a mobile terminal, to increase a display size of the mobile terminal and a screen-to-body ratio. The invention is defined by the appended claims. Further aspects are provided to facilitate understanding the invention.

This application provides a display module, where the display module includes a display screen and an optical fingerprint module, where the optical fingerprint module is located on a surface of the display screen away from a light-out surface and is fixedly connected to the display screen, a vertical projection of a fingerprint detection area of the optical fingerprint module on the light-out surface of the display screen is located inside a display area of the display screen, and light is able to be transmitted through the display screen to the fingerprint detection area.

In the foregoing technical solution, the optical fingerprint module is used to detect a fingerprint, and the optical fingerprint module is disposed under the display screen, so that a fingerprint can be collected when a finger presses the screen. Different from a mobile terminal in the prior art, because the optical fingerprint module is disposed under the display screen, no space of a front panel of the mobile terminal needs to be occupied, and more space can be used for disposition of the display screen, thereby increasing an area of the display screen, increasing a display size of the mobile terminal, and improving a screen-to-body ratio.

In a specific implementation solution, a display screen protective layer located on the surface of the display screen away from the light-out surface is further included, where the display screen protective layer is fixedly connected to the display screen; and a through hole is disposed at the display screen protective layer, and light is transmitted through the through hole to the fingerprint detection area. The display screen protective layer is used to protect the display screen, improving safety of the display screen.

In a specific implementation solution, the vertical projection of the fingerprint detection area on the light-out surface of the display screen is located inside a vertical projection of the through hole on the light-out surface of the display screen. This ensures that light can be transmitted to the fingerprint detection area, and improves fingerprint detection effect.

In a specific implementation solution, the optical fingerprint module is bonded to the display screen protective layer by using a bezel adhesive. The optical fingerprint module is fixedly connected to the display screen through bonding. During specific configuration, the bezel adhesive forms a frame shape, with the fingerprint detection area exposed in the middle.

In a specific implementation solution, the optical fingerprint module is bonded to the display screen by using a bezel adhesive. This ensures connection stability.

In a specific implementation solution, the optical fingerprint module is further bonded to the display screen by using an optical clear adhesive, and the optical clear adhesive is disposed in the fingerprint detection area. This further improves stability of the optical fingerprint module.

In a specific implementation solution, light transmittance of the optical clear adhesive is not less than 90%. This ensures that the optical fingerprint module works reliably.

In a specific implementation solution, the optical fingerprint module includes a sensor, a packaging layer for packaging the sensor, a flexible printed circuit board connected to the sensor, and a stiffener located on a surface of the packaging layer away from the display screen, and the stiffener is fixedly connected to the packaging layer.

In a specific implementation solution, the optical fingerprint module includes a sensor, a packaging layer for packaging the sensor, a flexible printed circuit board connected to the sensor, and a U-shaped support plate, where a concave area of the support plate is fixedly connected to the support place, a bending structure is disposed on each of two side walls of the support plate, and the bending structure is bonded to the display screen protective layer.

In a specific implementation solution, the bending structure is bonded to the display screen protective layer by using a bezel adhesive.

According to a second aspect, a mobile terminal is provided, where the mobile terminal includes a housing and the display module disposed in the housing according to any one of the foregoing implementation solutions.

In the foregoing technical solutions, the optical fingerprint module is used to detect a fingerprint, and the optical fingerprint module is disposed under the display screen, so that a fingerprint can be collected when a finger presses the screen. Different from a mobile terminal in the prior art, because the optical fingerprint module is disposed under the display screen, no space of a front panel of the mobile terminal needs to be occupied, and more space can be used for disposition of the display screen, thereby increasing an area of the display screen, increasing a display size of the mobile terminal, and improving a screen-to-body ratio.

### BRIEF DESCRIPTION OF DRAWINGS

FIG. 1 is a schematic structural diagram of a mobile terminal in the prior art;
FIG. 2 is a schematic structural diagram of a display module according to an embodiment of this application;
FIG. 3 shows a schematic structural diagram of a display module according to an embodiment of this application;
FIG. 4 is a schematic structural diagram of another display module according to an embodiment of this application;
FIG. 5 is a schematic structural diagram of another display module according to an embodiment of this application;
FIG. 6 is a schematic structural diagram of another display module according to an embodiment of this application;
FIG. 7 is a schematic structural diagram of another display module according to an embodiment of this application;
FIG. 8 is a schematic structural diagram of another display module according to an embodiment of this application; and
FIG. 9 is a schematic structural diagram of a mobile terminal according to an embodiment of this application.

### DESCRIPTION OF EMBODIMENTS

The following clearly and completely describes the technical solutions in the embodiments of this application with reference to the accompanying drawings in the embodiments of this application.

For easy understanding of the solutions in the embodiments of this application, an existing disposition manner of a fingerprint unlock structure 3 of a mobile terminal is first described. FIG. 1 shows a structure of a mobile terminal in the prior art. It can be seen from FIG. 1 that a display screen 2 and the fingerprint unlock structure 3 are disposed on a front panel 1 of the mobile terminal from top to bottom of the terminal. In this case, an area of a width d needs to be reserved on the front panel 1 for disposition of the fingerprint unlock structure 3. As a result, a non-display area on the mobile terminal is relatively wide and an area occupied by the display screen 2 is relatively small. In this disposition manner, a screen-to-body ratio (screen-to-body ratio = area of a display area of the display screen 2/area of the front panel 1) of the mobile terminal is relatively low. This is not conducive to improving the screen-to-body ratio.

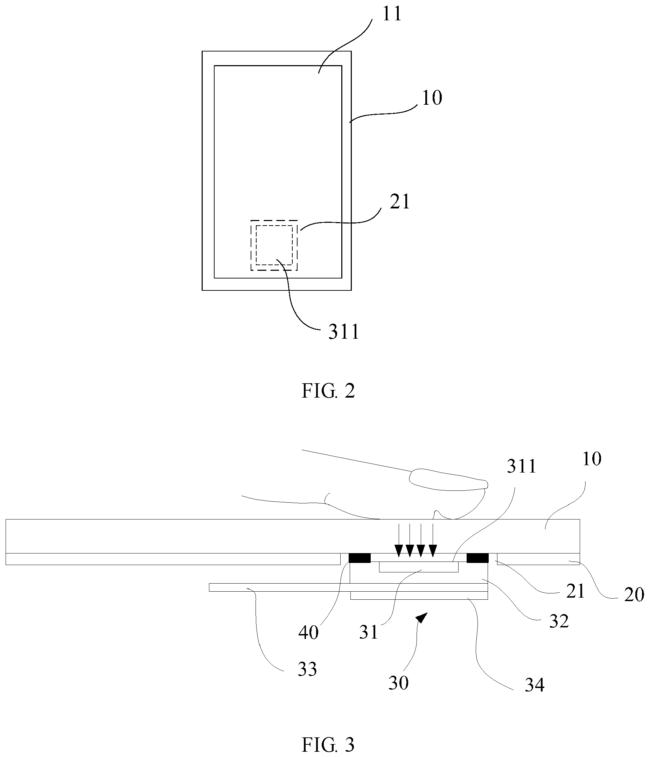

To improve the screen-to-body ratio of the mobile terminal, that is, to increase an area occupied by a display screen 10 without changing a front panel size of the mobile terminal, an embodiment of this application provides a display module. FIG. 2 is a top view of the display module, and FIG. 3 is a schematic structural diagram of the display module. The display module includes a display screen 10 and an optical fingerprint module 30. The optical fingerprint module 30 is located on a surface of the display screen 10 away from a light-out surface and is fixedly connected to the display screen 10. A vertical projection of a fingerprint detection area 311 of the optical fingerprint module 30 on the light-out surface of the display screen 10 is located inside a display area 11 of the display screen 10, and light is able to be transmitted through the display screen 10 to the fingerprint detection area 311.

FIG. 2 is a schematic structural diagram of the display module. It should be noted that the display screen 10 is an organic light-emitting diode (Organic Light-Emitting Diode, OLED) display screen. The display screen 10 includes a glass cover, an optical clear adhesive layer, a touch display module, and a protective layer that are sequentially stacked. The display screen 10 is a self-emissive display screen, and light emitted by the display screen 10 can be transmitted through the display screen 10, so that the display screen 10 can display a picture normally. In addition, external light can also reach the display screen 10, and go through the display screen 10 to the optical fingerprint module 30.

The display screen 10 includes the display area 11 and a non-display area, and the display area 11 and the non-display area are areas specified on the light-out surface of the display screen 10. As shown in FIG. 2, a middle part of the display screen 10 is the display area 11, and a part that encloses the display area 11 is the non-display area. The non-display area is a frame-shaped area used to cover wires on a display panel. In addition, to protect the display screen 10, a display screen protective layer 20 is disposed on the surface of the display screen 10 away from the light-out surface, and the display screen protective layer 20 is fixedly connected to the display screen 10. In addition, a through hole 21 is disposed at the display screen protective layer 20. The through hole 21 forms a path for receiving light, reflected by a finger, that is to reach the fingerprint detection area 311, and the reflected light goes through the through hole 21 to the fingerprint detection area 311. During specific configuration, the through hole 21 may be in different shapes, such as round, rectangular, or triangular.

A fingerprint detection apparatus in this embodiment is the optical fingerprint module 30. The optical fingerprint module 30 receives light reflected by a finger, and determines a fingerprint of the finger by using the reflected light. In this application, to improve the screen-to-body ratio of the mobile terminal, the optical fingerprint module 30 is disposed under the display screen 10, that is, the optical fingerprint module 30 is located on the surface of the display screen 10 away from the light-out surface. To ensure operating reliability of the optical fingerprint module 30, the fingerprint detection area 311 of the optical fingerprint module 30 is located inside the display area 11 of the display screen 10. During specific configuration, the following condition is met: The vertical projection of the fingerprint detection area 311 of the optical fingerprint module 30 on the light-out surface of the display screen 10 is located inside the display area 11 of the display screen 10. The fingerprint detection area 311 of the optical fingerprint module 30 is an area used to detect a fingerprint on the optical fingerprint module 30, and is a sensing area of a sensor 31 of the optical fingerprint module 30. During use, light emitted by the display screen 10 hits a fingerprint and is reflected by the fingerprint, and the reflected light can be transmitted through the display screen 10 to the fingerprint detection area 311 of the optical fingerprint module 30, so that optical fingerprint module 30 can work normally.

Referring to FIG. 2, a dashed-line box in FIG. 2 shows the fingerprint detection area 311 of the optical fingerprint module 30. FIG. 2 is a schematic structural diagram of the display module. The view is a view of the display module seen from above, and the light-out surface of the display screen 10 is vertical to an observation direction of the view. Therefore, a structure shown in FIG. 2 displays different components in a vertical direction on one plane, that is, the light-out surface, the fingerprint detection area 311, and the like are located on the same plane. Therefore, the dashed-line box representing the fingerprint detection area 311 may be understood as a position of the vertical projection on the light-out surface. It can be seen from FIG. 2 that the entire vertical projection falls inside the display area 11. In other words, the fingerprint detection area 311 is located inside the display area 11 of the display screen 10. Referring to FIG. 3, light reflected by a fingerprint can be transmitted to the fingerprint detection area 311.

In a specific implementation solution, the vertical projection of the fingerprint detection area on the light-out surface of the display screen 10 is located inside a vertical projection of the through hole 21 on the light-out surface of the display screen 10. This prevents the display screen protective layer 20 from blocking the light reflected by the fingerprint, ensures that the light can be transmitted to the fingerprint detection area, and improves fingerprint detection effect.

In addition, it should be understood that the fingerprint detection area 311 shown in FIG. 2 is in a rectangular shape, and the rectangular shape is merely a specific example of the fingerprint detection area 311. The fingerprint detection area 311 may be in different shapes, such as round, oval, or triangular. A specific shape of the fingerprint detection area 311 may be determined based on an actual design.

During specific configuration, only the fingerprint detection area 311, instead of an entire structure of the optical fingerprint module 30, needs to be located inside the display area 11. Any other structure of the optical fingerprint module 30 may or may not be located inside the display area 11. In a specific example, as shown in FIG. 3, the optical fingerprint module 30 includes a sensor 31, a packaging layer 32 for packaging the sensor 31, and a flexible printed circuit board 33 connected to the sensor 31. The packaging layer 32 wraps the sensor 31, with the fingerprint detection area 311 on the sensor 31 exposed. This not only improves safety of the sensor 31, but also ensures that the sensor 31 can receive the light reflected by the fingerprint. The flexible printed circuit board 33 is connected to the sensor 31, and is configured to transmit a signal detected by the sensor 31 to a control chip of the mobile terminal. In addition, to increase stiffness of the optical fingerprint module 30, a stiffener 34 is further disposed for the optical fingerprint module 30, and the stiffener 34 is fixedly connected to the packaging layer 32. The stiffener 34 is a metal plate or a plastic plate with some support stiffness, such as a steel plate, an iron plate, an aluminum plate, or a polyvinyl chloride plate. As shown in FIG. 3, the stiffener 34 is located on a surface of the packaging layer 32 away from the sensor 31. To be specific, the optical fingerprint module 30 is assembled behind the display screen 10, and the stiffener 34 is located on the surface of the packaging layer 32 away from the display screen 10. During specific configuration, the packaging layer 32 of the optical fingerprint module 30 may be located inside the display area 11 of the display screen 10, as shown in FIG. 2; or may be partially located outside the display area 11. This is not limited herein.

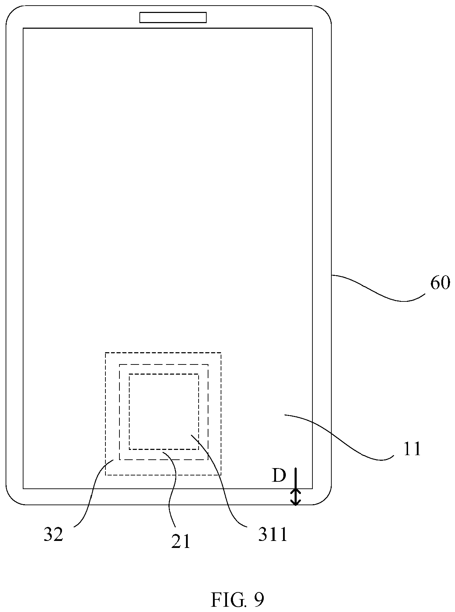

FIG. 9 is a schematic diagram of a mobile terminal to which the display module is applied according to this embodiment. The mobile terminal may be a common mobile terminal, such as a mobile phone or a tablet computer. Through comparison between FIG. 1 and FIG. 9, it can be learned that for the display module provided in this embodiment, the optical fingerprint module 30 is disposed under the display screen 10, so that no area needs to be reserved on the front panel of the mobile terminal for accommodating the optical fingerprint module 30, a width of an area originally used for disposition of the optical fingerprint module 30 can be reduced, and only a width D needs to be reserved for covering the non-display area of the display screen 10. In FIG. 1, an area of a width d needs to be reserved for disposition of the optical fingerprint module 30. It can be seen that D is far less than d, and a saved area can be used for disposition of the display screen 10, that is, the area of the display screen 10 is increased. When the front panel size of the mobile terminal is not changed, increasing the area of the display screen 10 improves the screen-to-body ratio of the mobile terminal.

During specific configuration, to secure the optical fingerprint module 30 and the display screen 10, in this embodiment of this application, the optical fingerprint module 30 is fixedly connected to the display screen 10. In addition, the connection may be implemented in different manners. The following provides details with reference to the specific accompanying drawings and embodiments.

### Embodiment 1

Still referring to FIG. 2 and FIG. 3, structures of the display screen 10 and the optical fingerprint module 30 in this embodiment are the same as the structures in the foregoing embodiment, and this embodiment is only to show a specific connection manner between the optical fingerprint module 30 and the display screen 10.

In this embodiment, the optical fingerprint module 30 is bonded to the display screen 10. Specifically, the optical fingerprint module 30 is bonded to the display screen 10 by using a bezel adhesive 40. As shown in FIG. 3, the bezel adhesive 40 is applied around the fingerprint detection area 311 of the sensor 31, and is bonded to the packaging layer 32. During connection, the display screen 10 and the packaging layer 32 are bonded together by using the bezel adhesive 40, to secure the optical fingerprint module 30 and the display screen 10.

In this case, as shown in FIG. 3, the through hole 21 of the display screen protective layer 20 is relatively large, and can accommodate the packaging layer 32 of the optical fingerprint module 30, thereby ensuring that the packaging layer 32 can be securely connected to the display screen 10.

In this connection manner, there is an air layer between the sensor 31 and the display screen 10, so that an air bubble that interferes with light transmission can be avoided during bonding.

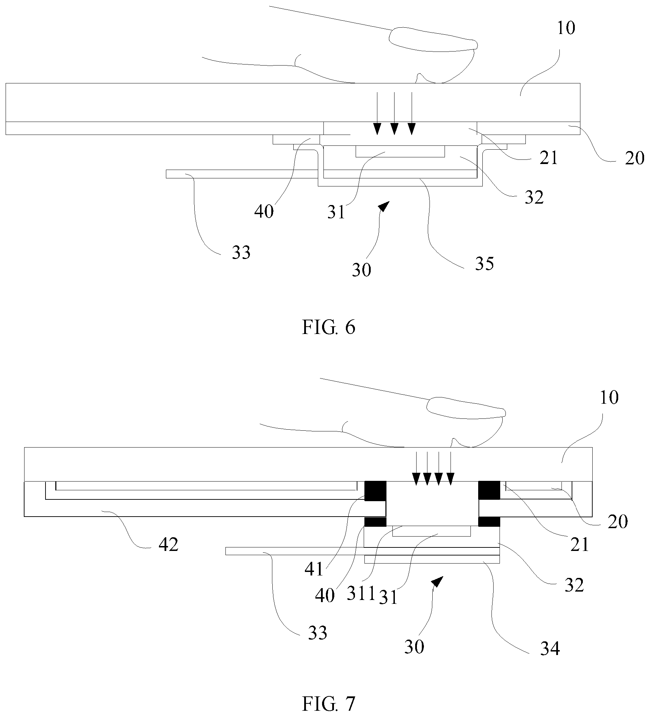

According to the invention as claimed, the optical fingerprint module 30 is connected to the display screen by using a middle frame 42. As shown in FIG. 7, the middle frame 42 has a second through hole 22 that is larger than the fingerprint detection area 311 and smaller than the through hole 21 of the display screen protective layer 20. A bezel adhesive 41 may be, for example, applied around the second through hole 42, to ensure bonding strength and dustproof performance. The middle frame 42 is connected to the display screen 10 by using the bezel adhesive 41, and a thickness of the bezel adhesive 41 only needs to be greater than or equal to that of the display screen protective layer 20. A gap between the middle frame 42 and the display screen protective layer 20 is not limited.

The optical fingerprint module 30 is bonded to a surface of the middle frame 42 away from the display screen 10 by using the bezel adhesive 40. As shown in FIG. 7, the bezel adhesive 40 is applied around the fingerprint detection area 311 of the sensor 31, and is bonded to the packaging layer 32. During connection, the middle frame 42 and the packaging layer 32 are bonded together by using the bezel adhesive 40, to secure the optical fingerprint module 30 and the middle frame 42.

A connection relationship between the middle frame 42 and the display screen 10 in FIG. 7 is only an example, and the relationship between the middle frame 42 and the display screen 10 may be adjusted based on an actual requirement. For example, a step-like structure (not shown in the figure) may be disposed at an end, connected to the display screen 10, of the middle frame 42, and protective glass (not shown in the figure) in the display screen 10 is connected to the step-like structure. The connection relationship between the middle frame 42 and the display screen 10, a specific structure of the middle frame 10, and a specific structure of the display screen are not described herein.

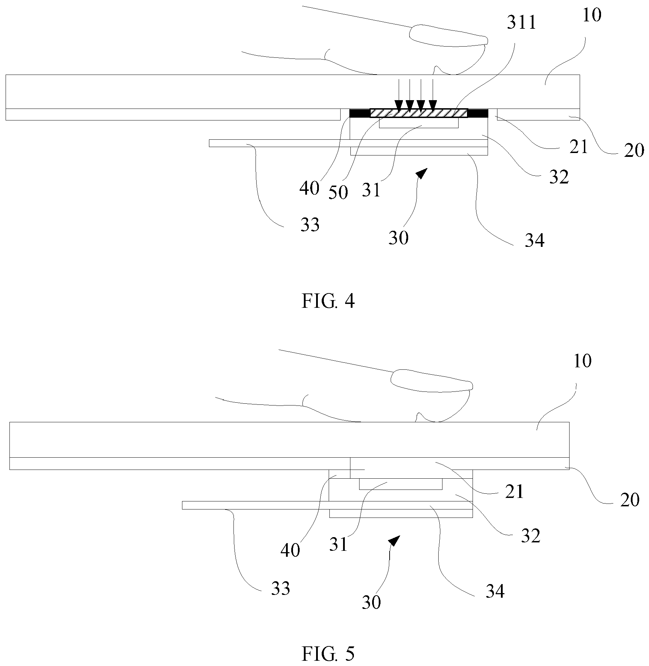

In a variant outside the scope of the invention as claimed, as shown in FIG. 4, the optical fingerprint module 30 is further bonded to the display screen 10 by using an optical clear adhesive 50, and the optical clear adhesive 50 is disposed in the fingerprint detection area. In other words, the optical fingerprint module 30 and the display screen 10 are connected by using both the bezel adhesive 40 and the optical clear adhesive 50. In this case, the optical clear adhesive 50 covers the fingerprint detection area 311, and the bezel adhesive 40 is applied around the optical clear adhesive 50. To ensure operating stability of the optical fingerprint module 30, light transmittance of the optical clear adhesive 50 is not less than 90%, for example, 90%, 95%, or 98%, so that light reflected by a fingerprint can be transmitted to the fingerprint detection area 311. The optical clear adhesive may be different adhesives, such as a polyurethane adhesive, a silicone gel adhesive, and a light-curing adhesive.

### Embodiment 2

As shown in FIG. 5, structures of the display screen 10 and the optical fingerprint module 30 in this embodiment are the same as the structures in the foregoing embodiments, and this embodiment is only to show a specific connection manner between the optical fingerprint module 30 and the display screen 10.

In this embodiment, the optical fingerprint module 30 is bonded to the display screen protective layer 20. Specifically, the optical fingerprint module 30 is bonded to the display screen protective layer 20 by using the bezel adhesive 40. As shown in FIG. 5, the bezel adhesive 40 is applied around the fingerprint detection area 311 of the sensor 31, and is bonded to the packaging layer 32. During connection, the display screen protective layer 20 and the packaging layer 32 are bonded together by using the bezel adhesive 40, to secure the optical fingerprint module 30 and the display screen 10.

In this case, as shown in FIG. 5, the through hole 21 of the display screen protective layer 20 is relatively small, and does not allow the packaging layer 32 to pass through, so that the display screen protective layer 20 can be bonded to the packaging layer 32.

In this connection manner, there is an air layer between the sensor 31 and the display screen 10, so that an air bubble that interferes with light transmission can be avoided during bonding.

In this manner, the display screen 10 is not in direct contact with the optical fingerprint module 30, thereby avoiding damage to the display screen 10 during an assembly or repairing process, and improving safety of the display screen 10.

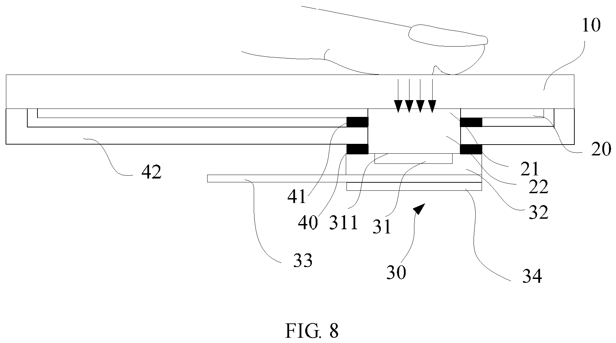

According to the invention as claimed, in a structure of the display module shown in FIG. 8, the optical fingerprint module 30 is further connected to the display screen protective layer 20 by using the middle frame 42. As shown in FIG. 8, the middle frame 42 has a second through hole 22 that is larger than the fingerprint detection area 311 and smaller than or equal to the through hole 21 of the display screen protective layer 20. The middle frame 42 is bonded to the display screen protective layer 20 by using the bezel adhesive 41, and the optical fingerprint module 30 is bonded to a surface of the middle frame 42 away from the display screen protective layer 20 by using the bezel adhesive 40.

### Embodiment 3

As shown in FIG. 6, which relates to a comparative example outside the scope of the invention as claimed, the optical fingerprint module 30 includes the sensor 31, the packaging layer 32 for packaging the sensor 31, and the flexible printed circuit board 33 connected to the sensor 31, and further includes a U-shaped support plate 35. A concave area of the support plate 35 is fixedly connected to the support plate 35, a bending structure is disposed on each of two side walls of the support plate 35, and the bending structure is bonded to the display screen protective layer 20. The U-shaped support plate 35 may be understood as a variant of the stiffener 34 in the foregoing embodiment. To be specific, two sides of the stiffener 34 extend and are bent to form a support structure, and the bending structure is bonded to the display screen protective layer 20. Specifically, the bending structure is bonded to the display screen protective layer 20 by using the bezel adhesive 40.

During connection, the bending structure is coated with a layer of bezel adhesive 40, and is bonded to the display screen protective layer 20 by using the bezel adhesive 40.

In this case, as shown in FIG. 6, the through hole 21 of the display screen protective layer 20 is relatively small, and does not allow the packaging layer 32 to pass through, so that the display screen protective layer 20 can be bonded to the packaging layer 32.

In this connection manner, there is an air layer between the sensor 31 and the display screen 10, so that an air bubble that interferes with light transmission can be avoided during bonding.

In this manner, the display screen 10 is not in direct contact with the optical fingerprint module 30, thereby avoiding damage to the display screen 10 during an assembly or repairing process, and improving safety of the display screen 10.

It can be learned from the specific Embodiment 1, Embodiment 2, and Embodiment 3 that the optical fingerprint module 30 and the display screen 10 may be fixedly connected in different manners in this embodiment. It should be understood that Embodiment 1, Embodiment 2, and Embodiment 3 are only examples of specific connection manners, in this embodiment, the display screen 10 and the optical module may be fixedly connected by using another known connection manner.

It should be noted that if the flexible printed circuit board (Flexible Printed Circuit, FPC) connected to the display screen 10 is bent and disposed under the through hole, it is self-evident that a second through hole with a shape and a size corresponding to the through hole 21 needs to be disposed on the FPC, to provide a necessary light path. Further, the middle frame 42 may be bonded to the FPC by using the bezel adhesive 41, or the optical fingerprint module 30 may be bonded to the FPC by using the bezel adhesive 40. More descriptions are not provided herein.

In addition, it should be noted that widths of the bezel adhesives 40 and 41 on a plane vertical to the light-out surface of the display screen 10 are not limited to the widths shown in FIG. 3 to FIG. 7, provided that the fingerprint detection area 311 of the optical fingerprint sensor 30 is not covered.

As shown in FIG. 9, the invention as claimed provides a mobile terminal, where the mobile terminal includes a housing and the display module disposed in the housing according to any one of the foregoing embodiments.

In the foregoing technical solutions, the optical fingerprint module 30 is used to detect a fingerprint, and the optical fingerprint module 30 is disposed under the display screen 10, so that a fingerprint can be collected when a finger presses the screen. Different from a mobile terminal in the prior art, because the optical fingerprint module 30 is disposed under the display screen 10, no space of the front panel of the mobile terminal needs to be occupied, and more space can be used for disposition of the display screen 10, thereby increasing an area of the display screen 10, increasing a display size of the mobile terminal, and improving the screen-to-body ratio.

FIG. 9 is a schematic diagram of a mobile terminal to which the display module is applied according to this embodiment. The mobile terminal may be a common mobile terminal, such as a mobile phone or a tablet computer. Through comparison between FIG. 1 and FIG. 9, it can be learned that for the display module provided in this embodiment, the optical fingerprint module 30 is disposed under the display screen 10, so that no area needs to be reserved on the front panel of the mobile terminal for accommodating the optical fingerprint module 30, a width of an area originally used for disposition of the optical fingerprint module 30 can be reduced, and only a width D needs to be reserved for covering the non-display area of the display screen 10. In FIG. 1, an area of a width d needs to be reserved for disposition of the optical fingerprint module 30. It can be seen that D is far less than d, and a saved area can be used for disposition of the display screen 10, that is, the area of the display screen 10 is increased. When the front panel size of the mobile terminal is not changed, increasing the area of the display screen 10 improves the screen-to-body ratio of the mobile terminal.

Obviously, a person skilled in the art can make various modifications and variations to the embodiments of this application without departing from the scope of this application. This application is intended to cover these modifications and variations provided that they fall within the scope of protection defined by the following claims.

## Claims

1. A display module, comprising an organic light-emitting diode, OLED, display screen (10), an optical fingerprint module (30) and a display screen protective layer (20), wherein
the optical fingerprint module (30) is located on a surface of the display screen (10) away from a light-out surface;
the optical fingerprint module (30) comprises a sensor (31), a packaging layer (32) for packaging the sensor (31) and a flexible printed circuit board (33) connected to the sensor (31); the sensor (31) comprises a fingerprint detection area (311), the packaging layer (32) packages the sensor (31) with the fingerprint detection area (311) on the sensor (31) exposed; the flexible printed circuit board (33) is configured to transmit a signal detected by the sensor (31); **characterized in that**
the display screen protective layer (20) is located on the surface of the display screen (10) away from the light-out surface; a through hole (21) is disposed at the display screen protective layer (20); the display screen protective layer (20) is fixedly connected to the display screen (10);
a vertical projection of the fingerprint detection area (311) of the optical fingerprint module (30) on the light-out surface of the display screen (10) is located inside a display area (11) of the display screen (10), and light is able to be transmitted through the display screen (10) and the through hole (21) to the fingerprint detection area (311);
the optical fingerprint module (30) is connected to the display screen protective layer (20) by using a middle frame (42), the optical fingerprint module (30) is bonded to the middle frame (42) by using a bezel adhesive (40), wherein a second through hole (22) is disposed at the middle frame (42);
the bezel adhesive (40) is applied around the fingerprint detection area (311) of the sensor (31) and is bonded to the packaging layer (32); and there is an air layer between the fingerprint detection area (311) and the display screen (10).

2. The display module according to claim 1, wherein the vertical projection of the fingerprint detection area (311) on the light-out surface of the display screen (10) is inside a vertical projection of the through hole (21) on the light-out surface of the display screen (10).

3. The display module according to claim 1 or 2, wherein the optical fingerprint module (30) further comprises a stiffener (34) located on a surface of the packaging layer (32) away from the display screen (10), and the stiffener (34) is fixedly connected to the packaging layer (32).

4. The display module according to claim 1 or 2, wherein the optical fingerprint module (30) further comprises a U-shaped support plate (35), wherein a concave area of the support plate (35) is fixedly connected to the support place, a bending structure is disposed on each of two side walls of the support plate (35), and the bending structure is bonded to the display screen protective layer (20).

5. The display module according to claim 4, wherein the bending structure is bonded to the display screen protective layer (20) by using the bezel adhesive (40).

6. A mobile terminal, comprising a housing and the display module disposed in the housing according to any one of claims 1 to 5.

## Patentansprüche

1. Anzeigemodul, einen organischen Leuchtdiodenanzeigeschirm, OLED-Anzeigeschirm, (10), ein optisches Fingerabdruckmodul (30) und eine Anzeigeschirmschutzschicht (20) umfassend, wobei
das optische Fingerabdruckmodul (30) auf einer Oberfläche des Anzeigeschirms (10) weg von einer unbeleuchteten Oberfläche lokalisiert ist;
das optische Fingerabdruckmodul (30) einen Sensor (31), eine Gehäuseschicht (32) zum Verkapseln des Sensors (31) und eine flexible Leiterplatte (33) umfasst, die mit dem Sensor (31) verbunden ist; der Sensor (31) einen Fingerabdruckdetektionsbereich (311) umfasst, die Gehäuseschicht (32) den Sensor (31) verkapselt, wobei der Fingerabdruckdetektionsbereich (311) auf dem Sensor (31) freiliegt; die flexible Leiterplatte (33) eingerichtet ist, um ein Signal zu übertragen, das von dem Sensor (31) detektiert wird; **dadurch gekennzeichnet, dass**
die Anzeigeschirmschutzschicht (20) auf der Oberfläche des Anzeigeschirms (10) weg von der unbeleuchteten Oberfläche lokalisiert ist; eine durchgehende Öffnung (21) an der Anzeigeschirmschutzschicht (20) angeordnet ist; die Anzeigeschirmschutzschicht (20) mit dem Anzeigeschirm (10) fest verbunden ist;
eine vertikale Projektion des Fingerabdruckdetektionsbereichs (311) des optischen Fingerabdruckmoduls (30) auf die unbeleuchtete Oberfläche des Anzeigeschirms (10) innerhalb einer Anzeigefläche (11) des Anzeigeschirms (10) lokalisiert ist und Licht durch den Anzeigeschirm (10) und die durchgehende Öffnung (21) an den Fingerabdruckdetektionsbereich (311) übertragen werden kann;
das optische Fingerabdruckmodul (30) unter Verwendung eines Mittelrahmens (42) mit der Anzeigeschirmschutzschicht (20) verbunden ist, das optische Fingerabdruckmodul (30) unter Verwendung eines Einfassungsklebstoffs (40) an den Mittelrahmen (42) gebondet ist, wobei an dem Mittelrahmen (42) eine zweite durchgehende Öffnung (22) angeordnet ist;
der Einfassungsklebstoff (40) um den Fingerabdruckdetektionsbereich (311) des Sensors (31) herum aufgebracht ist und an die Gehäuseschicht (32) gebondet ist; und eine Luftschicht zwischen dem Fingerabdruckdetektionsbereich (311) und dem Anzeigeschirm (10) vorhanden ist.

2. Anzeigemodul nach Anspruch 1, wobei die vertikale Projektion des Fingerabdruckdetektionsbereichs (311) auf die unbeleuchtete Oberfläche des Anzeigeschirms (10) innerhalb einer vertikalen Projektion der Durchlassöffnung (21) auf die unbeleuchtete Oberfläche des Anzeigeschirms (10) ist.

3. Anzeigemodul nach Anspruch 1 oder 2, wobei das optische Fingerabdruckmodul (30) weiterhin eine Versteifung (34) umfasst, die auf einer Oberfläche der Gehäuseschicht (32) weg von dem Anzeigeschirm (10) angeordnet ist, und die Versteifung (34) mit der Gehäuseschicht (32) fest verbunden ist.

4. Anzeigemodul nach Anspruch 1 oder 2, wobei das optische Fingerabdruckmodul (30) weiterhin eine U-förmige Trägerplatte (35) umfasst, wobei eine konkave Fläche der Trägerplatte (35) mit dem Trägerort fest verbunden ist, eine Biegestruktur auf jeder von zwei Seitenwänden der Trägerplatte (35) angeordnet ist und die Biegestruktur an die Anzeigeschirmschutzschicht (20) gebondet ist.

5. Anzeigemodul nach Anspruch 4, wobei die Biegestruktur unter Verwendung des Einfassungsklebstoffs (40) an die Anzeigeschirmschutzschicht (20) gebondet ist.

6. Mobiles Endgerät, ein Gehäuse und das Anzeigemodul, das in dem Gehäuse angeordnet ist, nach einem der Ansprüche 1 bis 5 umfassend.

## Revendications

1. Module d'affichage, comprenant un écran d'affichage (10) à diode électroluminescente organique, DELO, un module optique d'empreintes digitales (30) et une couche de protection (20) d'écran d'affichage, dans lequel
le module optique d'empreintes digitales (30) est situé sur une surface de l'écran d'affichage (10) à l'écart d'une surface de sortie de lumière ;
le module optique d'empreintes digitales (30) comprend un capteur (31), une couche d'encapsulation (32) pour encapsuler le capteur (31) et une carte de circuit imprimé flexible (33) reliée au capteur (31) ; le capteur (31) comprend une zone de détection d'empreintes digitales (311), la couche d'encapsulation (32) encapsule le capteur (31) avec la zone de détection d'empreintes digitales (311) sur le capteur (31) exposé ; la carte de circuit imprimé flexible (33) est configurée pour transmettre un signal détecté par le capteur (31) ; **caractérisé en ce que**
la couche de protection (20) d'écran d'affichage est située sur la surface de l'écran d'affichage (10) à l'écart de la surface de sortie de lumière ; un trou traversant (21) est disposé au niveau de la couche de protection (20) d'écran d'affichage ; la couche de protection (20) d'écran d'affichage est reliée à demeure à l'écran d'affichage (10) ; une projection verticale de la zone de détection d'empreintes digitales (311) du module optique d'empreintes digitales (30) sur la surface de sortie de lumière de l'écran d'affichage (10) est située à l'intérieur d'une zone d'affichage (11) de l'écran d'affichage (10), et la lumière est susceptible d'être transmise à travers l'écran d'affichage (10) et le trou traversant (21) vers la zone de détection d'empreintes digitales (311) ;
le module optique d'empreintes digitales (30) est relié à la couche de protection (20) d'écran d'affichage en utilisant un cadre médian (42), le module optique d'empreintes digitales (30) est collé au cadre central (42) en utilisant un adhésif de contour d'écran (40), dans lequel un second trou traversant (22) est disposé au niveau du cadre médian (42) ;
l'adhésif de contour d'écran (40) est appliqué autour de la zone de détection d'empreintes digitales (311) du capteur (31) et est collé à la couche d'encapsulation (32) ; et
une couche d'air se situe entre la zone de détection d'empreintes digitales (311) et l'écran d'affichage (10).

2. Module d'affichage selon la revendication 1, dans lequel la projection verticale de la zone de détection d'empreintes digitales (311) sur la surface de sortie de lumière de l'écran d'affichage (10) est à l'intérieur d'une projection verticale du trou traversant (21) sur la surface de sortie de lumière de l'écran d'affichage (10).

3. Module d'affichage selon la revendication 1 ou 2, dans lequel le module optique d'empreintes digitales (30) comprend en outre un raidisseur (34) situé sur une surface de la couche d'encapsulation (32) à l'écart de l'écran d'affichage (10), et le raidisseur (34) est relié à demeure à la couche d'encapsulation (32).

4. Module d'affichage selon la revendication 1 ou 2, dans lequel le module optique d'empreintes digitales (30) comprend en outre une plaque de support en forme de U (35), dans lequel une zone concave de la plaque de support (35) est reliée à demeure à l'emplacement de support, une structure de flexion est disposée sur chacune des deux parois latérales de la plaque de support (35), et la structure de flexion est collée à la couche de protection (20) d'écran d'affichage.

5. Module d'affichage selon la revendication 4, dans lequel la structure de flexion est collée à la couche de protection (20) d'écran d'affichage en utilisant l'adhésif de contour d'écran (40).

6. Terminal mobile, comprenant un boîtier et le module d'affichage disposé dans le boîtier selon l'une quelconque des revendications 1 à 5.
